# EUROPEAN PATENT SPECIFICATION

(11) **EP 2 463 334 B1**
(45) Date of publication and mention of the grant of the patent: **27.03.2013**
(21) Application number: 11191488.3
(22) Date of filing: 01.12.2011
(51) Int. Cl.: C08K 5/56, C08G 77/20, G02B 1/04

(54) **Method for curing a silicone resin composition**
Verfahren zum Härten einer Siliciumharzzusammensetzung
Procédé pour le durcissement d'une composition de résine de silicone

(30) Priority: 07.12.2010 JP 2010272521
(43) Date of publication of application: 13.06.2012
(73) Proprietor: Shin-Etsu Chemical Co., Ltd., Tokyo 100-0004 (JP)
(72) Inventor: Inafuku, Kenichi, Matsuida-machi, Annaka-shi, Gunma 379-0224 (JP); Wakao, Miyuki, Matsuida-machi, Annaka-shi, Gunma 379-0224 (JP); Kashiwagi, Tsutomu, Matsuida-machi, Annaka-shi, Gunma 379-0224 (JP)
(74) Representative: Jansen, Cornelis Marinus

(56) References cited:
- JP-A- 2010 047 646

## Description

### CROSS REFERENCE

This application claims the benefits of Japanese Patent Application No. 2010-272521 filed on December 7, 2010 the contents of which are herein incorporated by reference.

### FIELD OF THE INVENTION

The present invention relates to a method for curing a silicone resin composition. Specifically, the present invention relates to a method for curing a silicone resin composition with heat, comprising a step of irradiating the silicone resin composition with light before a step of heating. Further, the present invention relates to a cured product obtained from the method and a semiconductor device provided with the cured product.

### BACKGROUND OF THE INVENTION

Silicone resins and silicone elastomers have good heat resistance and light resistance and can provide a transparent molded product and cured product and, therefore, are used for various optical applications. In particular, silicone resins and silicone elastomers are suitable for applications such as encapsulation materials, protective materials and lenses for LEDs which are recently required to have high brightness associated with large heat generation.

An addition-curable silicone resin composition which is cured with heat generally has a platinum catalyst as a curing catalyst. In such a silicone resin composition, the platinum catalyst is active even right after preparing the composition and, therefore, a curing inhibitor needs to be added to secure the pot life of the composition. However, another problem arises in return, such that the curing rate of the silicone resin composition decelerates, so that the composition flows during heating before the composition is completely cured and the shape of the product obtained changes. Therefore, control of production lines and a high-temperature oven are needed.

Japanese Patent Application Laid-Open No.2009-235265 discloses a heat-curable silicone resin composition comprising fumed silica. The silicone resin composition has good thixotropy and, therefore, is applied on an LED chip equipped on a frame with a dispenser and cured to form a coating or encapsulated product having a stable shape of lens. However, the light permeability of the cured product obtained in this method and the pot life of the silicone resin composition are poor.

Japanese Patent Application Laid-Open No.2010-47646 discloses a light-curable organopolysiloxane composition comprising (methylcyclopentadienyl)trimethyl platinum as a curing catalyst. (Methylcyclopentadienyl)trimethyl platinum does not become active unless irradiated with light. Before the composition is irradiated with light, the viscosity of the composition does not increase and, therefore, the pot life of the composition is good. Japanese Patent Application Laid-Open No.2010-47646 also discloses a method where the organopolysiloxane composition is irradiated with light having wavelength of 200nm to 400nm so as to activate (methylcyclopentadienyl)trimethyl platinum to cure the organopolysiloxane composition.

### PRIOR LITERATURE

### [Patent Literature]

[Patent Literature 1] Japanese Patent Application Laid-Open No.2009-235265
[Patent Literature 2] Japanese Patent Application Laid-Open No.2010-47646

### DISCLOSURE OF THE INVENTION

### PROBLEMS TO BE SOLVED BY THE INVENTION

However, the method described in Japanese Patent Application Laid-Open No.2010-47646 (Patent Literature 2) has a problem that the organopolysiloxane resin composition flows before the composition is completely cured and, therefore, a cured product having a desired shape cannot be obtained. Accordingly, one object of the present invention is to provide a method for curing a silicone resin composition where the silicone resin composition can be cured keeping the shape which the composition has in an initial stage of a heating step.

### MEANS TO SOLVE THE PROBLEMS

To solve the aforesaid problems, the present inventors have conducted research on conditions of irradiating the silicon resin composition with light and found that when a silicone resin composition is irradiated with light which has a maximum peak of irradiance in a region of wavelengths of 300nm to 400nm and irradiance of light of wavelength shorter than 300nm is 5 % or less of the irradiance at the maximum peak, the silicone resin composition loses the flowability, that is, the composition can gel in a very short irradiation time. Further, the present inventors have found that the composition with no flowability can be cured with heat while the composition does not flow until complete cure, keeping the shape which the composition has in an initial stage of the heating step.

Thus, the present invention provides a method for curing a silicone resin composition with heat,
wherein the silicone resin composition comprises
(A) an organopolysiloxane having at least two alkenyl groups per molecule,
(B) an organohydrogenpolysiloxane having, per molecule, at least two hydrogen atoms each bonded to a silicon atom in such an amount that the ratio of the total mole of the hydrogen atoms bonded to the silicon atom in the component(B) to the total mole of the alkenyl groups in the component (A) is 0.1 to 4.0, and (C) a catalytic amount of a photoactive catalyst,
wherein the method is characterized by comprising a step of irradiating the silicone resin composition with light before the step of heating, the light has a maximum peak of irradiance in the region of wavelengths of 300 to 400nm and the irradiance of light of wavelength shorter than 300nm is 5 % or less of the irradiance at the maximum peak.

### EFFECTS OF THE INVENTION

The present method is characterized in that the method comprises a step of irradiating a silicone resin composition with light having a specific wavelength before heating. On account of the step, a silicone resin composition loses the flowability in a very short irradiation time and, therefore, can be cured without flowing in a subsequent heating step. Therefore, the present method can provide a cured product having a desired shape. Further, the cured product obtained in the present method has good heat resistance and transparency and is useful as an encapsulating material for optical semiconductor elements such as light-emitting diodes.

### BRIEF DESCRIPTION ON A DRAWING

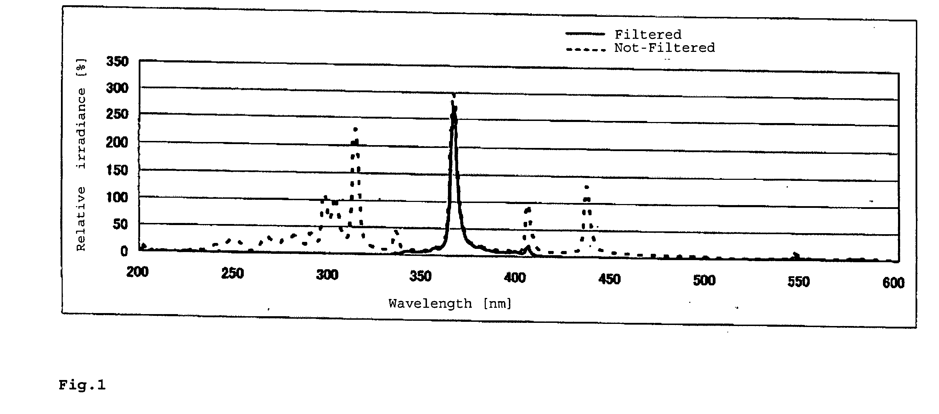

Fig.1 shows emission spectra of light which silicone resin compositions in Examples 4 to 6 were irradiated with.

### BEST MODES OF THE INVENTION

### Method for curing the silicone resin composition

The present invention is a method for curing the silicone resin composition comprising the afore-mentioned components (A) to (C) with heat. The present method is characterized in that the method comprises a step of irradiating the silicone resin composition with light having the specific wavelength before heating. In the present method, the irradiation light has a maximum peak of irradiance in the region of wavelengths of 300nm to 400nm and the irradiance of light of wavelength shorter than 300nm is 5 % or less, preferably 1 % or less, more preferably 0.1% or less, of the irradiance at the maximum peak. If a resin composition is irradiated with light where an irradiance of light of wavelength shorter than 300nm is more than 5 % of the irradiance at the maximum peak, a part of the catalyst loses the activity and the resin composition does not gel. In particular, preferred is that the irradiance of light of wavelength shorter than 300nm is closer to zero.

Active light used for the present method is not particularly limited, but ultraviolet rays are preferred. An ultraviolet irradiance level, i.e. illuminance, is 100 to 100,000mJ/cm², preferably 100 to 10,000mJ/cm², more preferably 100 to 5,000mJ/cm² as an integrated light quantity. When the ultraviolet irradiance level is in the aforesaid range, the silicone resin composition can be cured in a very short irradiation time.

The ultraviolet rays may be light having plural emission spectra or a single emission spectrum. Further, a single emission spectrum may be a broad spectrum in a region of 300 to 400nm. The light having a single emission spectrum has a peak, i.e. maximum peak of an irradiance, in a region of 300 to 400nm, preferably 350 to 380nm. Examples of a light source which emits light having such a single emission spectrum include ultraviolet-emitting semiconductor light sources such as an ultraviolet-emitting diode (UV-LED) and an ultraviolet-emitting laser.

Examples of the light source emitting light having several emission spectra include lamps such as a metal halide lamp, a xenon lamp, a carbon-arc lamp, a chemical lamp, a sodium lamp, a low pressure mercury lamp, a high pressure mercury lamp and an extra high pressure mercury lamp; gas lasers such as a nitrogen gas laser; liquid lasers using organic dye solutions; solid-state lasers of an inorganic single crystal containing a rare-earth ion. For example, an ultraviolet irradiation equipment having a conveyor can be used.

In the case where the light has a peak of irradiance in a region of wavelength shorter than 300nm or has an irradiance in a region of wavelength shorter than 300nm and is more than 5 % of the irradiance at the maximum peak, so that, spectrum is broad over a wide wavelength region, the light of wavelength shorter than 300nm is cut with an optical filter. By this means, an irradiance of the light of wavelength shorter than 300nm is made 5% or less, preferably 1 % or less, more preferably 0.1 % or less, further preferably 0 %, of the irradiance at the maximum peak. If the light has plural peaks in a spectral region of 300 to 400nm, the peak which has the biggest irradiance is regarded as a maximum peak of the irradiance. The optical filter is not particularly limited as long as it can cut light of wavelength shorter than 300nm, such as a commonly used filter, for instance, a 365 nm Band Pass Filter. An irradiance and a spectral distribution of ultraviolet can be determined with a spectroradiometer such as USR-45D, ex. Ushio Inc.

The time period of irradiating the silicone resin composition with light may be very short. For instance, when the silicone resin composition is irradiated for 0.5 to 10 seconds, particularly 1 to 5 seconds, it then gels in subsequent 10 to 600 seconds, particularly 60 to 300 seconds. In the present invention, gelation means that the resin composition is partially cured and loses flowability. On account of the gelation, the composition can be cured keeping the initial shape without flowing before the composition is completely cured in the subsequent heating step.

According to the present method, the silicone resin composition is applied with a dispenser device, for instance, on a LED chip equipped on a frame, the light having the afore-mentioned wavelength is irradiated to the composition to make it gel, and subsequently the composition is heated so as to be cured to form a layer and an encapsulated product having a constant shape of lens.

### Silicone resin composition

The present silicone resin composition comprises the aforesaid components (A) to (C). Each component will be explained below.

### (A) Organopolysiloxane having alkenyl groups

The component (A) is an organopolysiloxane having at least two alkenyl groups per molecule. Examples of the alkenyl group include alkenyl and cycloalkenyl groups having 2 to 8, preferably 2 to 6 carbon atoms. In particular, the alkenyl group includes vinyl, allyl, propenyl, isopropenyl, butenyl, pentenyl and hexenyl groups, and the cycloalkenyl group includes a cyclohexenyl group. Among these, vinyl and allyl groups are preferred. The organopolysiloxane may be a solid or viscous resin at room temperature. The organopolysiloxane preferably has a viscosity at 23 degrees C. of 10 to 1,000,000 mPa·s, more preferably 100 to 100,000 mPa·s in view of workability and curability. Therefore, when the organopolysiloxane is solid at 23 degrees C., a solvent may be used in combination with the organopolysiloxane to attain the aforesaid viscosity. The viscosity is determined, for instance, with a rotational viscometer. Examples of the solvent used in combination with the organopolysiloxane include toluene, heptane and cyclohexane. The amount of the solvent may be adjusted so that the viscosity of the oraganopolysiloxane with the solvent is in the aforesaid range.

The organopolysiloxane preferably has a three dimensional network which comprises SiO_{4/2} units, hereinafter referred to as Q units, and R₃SiO_{1/2} units, hereinafter referred to as M units . The organopolysiloxane may further comprise R₂SiO units, hereinafter referred to as D units, and/or RSiO_{3/2} units, hereinafter referred to as T units. Preferably the ratio of the M units to the Q units of the organopolysiloxane, as a molar ratio, ranges from 1:0.5 to 1:3, more preferably 1:0.6 to 1:2.5. When the organopolysiloxane comprises the D units and/or the T units, the amount of these units ranges preferably from 30 to 70 mole%, more preferably 40 to 60 mole %, relative to the total mole of the siloxane units. The weight average molecular weight of the organopolysiloxane, as determined by GPC using tetrahydrofuran as a solvent, reduced to polystyrene, is preferably in the range of 10 to 1, 000, 000, more preferably 100 to 100,000.

In the afore-mentioned units, R is, independently of each other, a substituted or unsubstituted, monovalent hydrocarbon group having 1 to 10, preferably 1 to 6 carbon atoms, provided that, at least two of the groups represented by R are an alkenyl group. Examples of R include alkyl groups such as methyl, ethyl, propyl, isopropyl, butyl, isobutyl, tert-butyl, pentyl, neopentyl, hexyl, octyl, nonyl and decyl groups; cyclohexyl group; aryl groups such as phenyl, tolyl, xylyl and naphthyl groups; aralkyl groups such as benzyl, phenylethyl and phenylpropyl groups; alkenyl groups such as vinyl, allyl, propenyl, isopropenyl, butenyl, pentenyl, hexenyl and octenyl groups; and cyclohexenyl, where a part or all of their hydrogen atoms are replaced with a halogen atom(s), such as fluorine, bromine and chlorine atoms, or with a cyano group, to give, for instance, halogen-substituted alkyl groups, such as, chloromethyl, chloropropyl, bromoethyl and trifluoropropyl groups, and a cyanoethyl group.

The organopolysiloxane having a three dimensional network may further comprise small amounts of bifunctional siloxane units and trifunctional siloxane units, that is, organosilsesquioxane units, in addition to the aforesaid units, as long as the purposes of the present invention are not obstructed.

The organopolysiloxane having a three dimensional network can be easily prepared by combining source compounds for the aforesaid M, Q, D and T units so that the afore-mentioned molar ratios are met and subjecting them to co-hydrolysis, for instance, in the presence of an acid. As the source compounds for the M, Q, D and T units, the following silane compound may be used:

RₙSiX₄₋ₙ

wherein, R is as defined above, X is a halogen atom or alkoxy groups having 1 to 4 carbon atoms, and n is an integer of 1 to 3 or zero. Preferably, X is a halogen atom, in particular, a chlorine atom.

Examples of the silane compound include methyltrichlorosilane, vinyltrichlorosilane, methyltrimethoxysilane, methyltriethoxysilane, vinylmethyldichlorosilane, vinylmethyldimethoxysilane, vinylmethyldiethoxysilane, dimethyldichlorosilane, trimethylmethoxysilane, trimethylchlorosilane, trivinylchlorosilane, vinyldimethylchlorosilane, tetrachlorosilane, tetramethoxysilane and tetraethoxysilane. A compound such as a silicate soda, alkylsilicate and polyalkylsilicate may also be used as the source compounds for the Q units.

The present component (A) may be a mixture of a liner organopolysiloxane with the afore-mentioned organopolysiloxane having a three dimensional network. The liner organopolysiloxane preferably has a main chain composed of repeating diorganosiloxane units with both ends capped with a triorganosiloxy group. Particularly, desired is a linear organopolysiloxane represented by the following general formula. The linear organopolysiloxane may comprise a small amount of branched structure in its molecular chain.

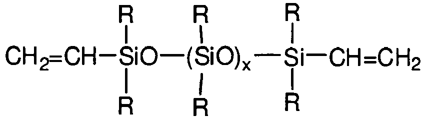

wherein x is zero or a positive integer, preferably an integer of from 1 to 10,000, more preferably 5 to 2,000, and is such as to give a viscosity at 23 degrees C. of 10 to 1, 000, 000 mPa·s, preferably 100 to 100,000 mPa·s. R is as defined above.

When the component (A) contains the liner organopolysiloxane, this organopolysiloxane is preferably blended in an amount of 20 to 70 mass %, more preferably 30 to 60 mass %, in the component (A). If the amount of the organopolysiloxane having a three dimensional network is too small, strength of the cured product obtained may be too little. If the amount is too large, the viscosity of the composition is so high that cracks may occur often in a cure product.

### (B) Organohydrogenpolysiloxane

The component (B) is an organohydrogenpolysiloxane having, in a molecule, at least two, preferably at least three, for instance, 3 to 1,000, preferably 3 to 500, more preferably 3 to 200, further preferably 4 to 100, hydrogen atoms each bonded to a silicon atom, referred to as "SiH". The SiH group of the organohydrogenpolysiloxane reacts with the alkenyl group in the component (A) to provide a cured product. The position of the hydrogen atom bonded to a silicon atom is not particularly limited and may be either or both of the terminals of the molecule. The structure of the organohydrogenpolysiloxane (B) is not particularly limited as long as it meets the aforesaid conditions and various organohydrogenpolysiloxanes which have a linear, cyclic, branched or three-dimensional network structure may be used.

The number of the silicon atoms in one molecule, that is, the degree of polymerization, is usually 2 to 1, 000, preferably 3 to 500, more preferably 4 to 150. Preferably, the organohydrogenpolysiloxane has a viscosity at 23 degrees C. of 0.1 to 100,000 mPa·s, more preferably 0.5 to 5,000 mPa·s and is liquid at room temperature, 23 degrees C.

The organohydrogenpolysiloxane may have the following average compositional formula.

R¹_{b}H_{c}SiO_{(4-b-c)/2}

wherein R¹ is a substituted or unsubstituted, monovalent hydrocarbon group with 1 to 10 carbon atoms and is not an alkenyl group, b is the number of 0.7 to 2.1, c is the number of 0.001 to 1.0, provided that b + c is 0.8 to 3.0. Preferably, b is the number of 1.0 to 2.0, c is the number of 0.01 to 1.0, provided that b + c is 1.5 to 2.5.

Examples of the monovalent hydrocarbon group represented by the aforesaid R¹ include alkyl groups such as methyl, ethyl, propyl, isopropyl, butyl, isobutyl, tert-butyl, pentyl, neopentyl, hexyl, octyl, nonyl and decyl groups; cyclohexyl group; aryl groups such as phenyl, tolyl, xylyl and naphthyl groups; aralkyl groups such as benzyl, phenylethyl and phenylpropyl groups; and those groups where a part or all of their hydrogen atoms are replaced with a halogen atom(s), such as fluorine, bromine and chlorine atoms, for instance, chloromethyl, chloropropyl, bromoethyl and trifluoropropyl groups. Among these, alkyl and aryl groups are preferred, and methyl and phenyl groups are more preferred.

This organohydrogenpolysiloxane having a branched or three dimensional network can be prepared, for instance, by hydrolyzing chlorosilane represented by R¹SiCl₃, R¹SiHCl₂, R¹₃SiCl, R¹₂SiCl₂ or R¹₂SiHCl wherein R¹ is as defined above, or by equilibrating the resulting siloxanes.

Examples of the organohydrogenpolysiloxane having a branched or three dimensional network include tris(dimethylhydrogensiloxy)methylsilane, tris(dimethylhydrogensiloxy)phenylsilane, copolymers composed of (CH₃)₂HSiO_{1/2} units, (CH₃)₃SiO_{1/2} units and SiO_{4/2} units, and copolymers composed of (CH₃)₂HSiO_{1/2} units and SiO_{4/2} units, copolymers composed of (CH₃)₂HSiO_{1/2} units, SiO_{4/2} units and (C₆H₅)SiO_{3/2} units. In particular, the following organohydrogenpolysiloxanes represented can be used.

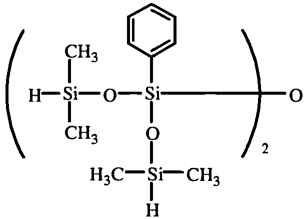

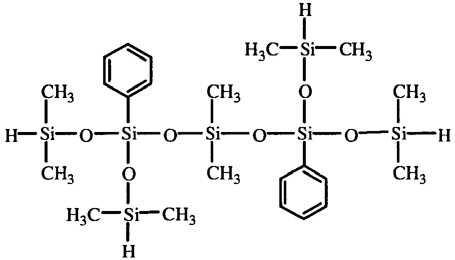

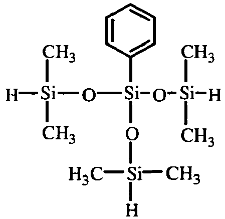

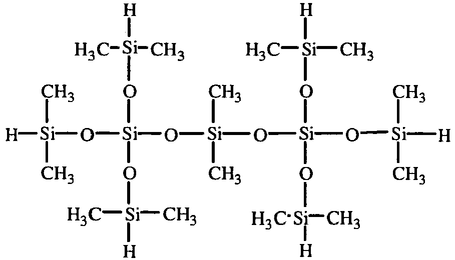

Examples of the cyclic or linear organohydrogenpolysiloxane include 1,1,3,3-tetramethyldisiloxane, 1,3,5,7-tetramethylcyclotetrasiloxane, tris(hydrogendimethylsiloxy)methylsilane, tris(hydrogendimethylsiloxy)phenylsilane, methylhydrogencyclopolysiloxane, cyclic copolymers of methylhydrogensiloxane and dimethylsiloxane, methylhydrogenpolysiloxane with both ends blocked with trimethylsiloxy groups, copolymers of dimethylsiloxane and methylhydrogensiloxane with both ends blocked with trimethylsiloxy groups, dimethylpolysiloxane with both ends blocked with dimethylhydrogensiloxy groups, copolymers of dimethylsiloxane and methylhydrogensiloxane with both ends blocked with dimethylhydrogensiloxy groups, copolymers of methylhydrogensiloxane and diphenylsiloxane with both ends blocked with trimethylsiloxy groups, copolymers of methylhydrogensiloxane, diphenylsiloxane and dimethylsiloxane with both ends blocked with trimethylsiloxy groups, copolymers of methylhydrogensiloxane, methylphenylsiloxane and dimethylsiloxane with both ends blocked with trimethylsiloxy groups, copolymers of methylhydrogensiloxane, dimethylsiloxane and diphenylsiloxane with both ends blocked with dimethylhydrogensiloxy groups, and copolymers of methylhydrogensiloxane, dimethylsiloxane and methylphenylsiloxane with both ends blocked with dimethylhydrogensiloxy groups.

Further, the linear organohydrogenpolysiloxane may have the following structure. 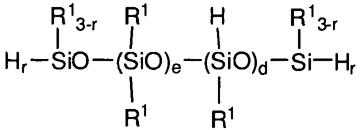 wherein e and d satisfy the following equations, 0 <= e <= 998, 0 < d <= 998 and 1 < e + d <= 998, preferably the equation, 1 < e + d <= 289, more preferably 2 < e + d <= 148, r is an integer of 0 to 3, and R¹ is as defined above, provided that the organohydrogenpolysiloxane has, in a molecule, at least two hydrogen atoms each bonded to a silicon atom.

The amount of the organohydrogenpolysiloxans (B) is preferably such that the ratio of the total mole of the hydrogen atoms bonded to the silicon atom in the component (B) to the total mole of the alkenyl groups in the component (A) is 0.1 to 4.0, more preferably 0.8 to 3.0, further preferably 0.9 to 2.0. If the amount is larger than the afore-mentioned upper limit, a lot of unreacted SiH groups remain in a cured product to cause change in its physical properties with time. Where the present silicone composition comprises an adhesion-imparting agent (D) as explained below and the adhesion-imparting agent has an alkenyl group, the amount of the component (B) is such that the ratio of the total mole of the hydrogen atoms bonded to the silicon atom in component (B) to the total mole of the alkenyl groups in component (A) and an adhesion-imparting agent (D) is in the aforesaid range.

### (C) Photoactive catalyst

The component (C) may be any catalyst having photoactivity, in particular, platinum group-metal catalysts and nickel series catalysts. The platinum group-metal catalysts may be a compound of platinum, palladium or rhodium and, among these, a platinum catalyst is preferred. Examples of the platinum catalyst include platinum beta-diketonate complexes such as trimethyl(acetylacetonato)platinum(II) complexes, trimethyl(3,5-heptanedionate)platinum(II) complexes, trimethyl(methylacetoacetate)platinum(II) complexes, bis(2,4-pentanedionato)platinum(II) complexes, bis(2,4-hexanedionato)platinum(II) complexes, bis(2,4-heptanedionato)platinum(II) complexes, bis(3,5-heptanedionato)platinum(II) complexes, bis(1-phenyl-1,3-butanedionato)platinum(II) complexes and bis(1,3-diphenyl-1,3-propanedionato)platinum(II) complexes. Further, trimethyl(methylcyclopentadienyl)platinum(IV) can be used. Examples of the nickel series catalysts include bis(2,4-pentanedionato)nickel(II) complexes. The aforesaid catalysts may be used alone or in a combination of two or more. In particular, bis(2,4-pentanedionato)platinum(II) complexes, so-called bis(acetylacetonato)platinum(II), is preferably used in the present method.

The catalyst may be used in a catalytic amount, preferably 0.1 to 1,000 ppm, more preferably 0.5 to 200 ppm, calculated as a platinum group metal, relative to the total amount of components (A) and (B) . When the amount is in the aforesaid range, the silicone resin composition can be cured in a short time.

### (D) Adhesion-imparting agent

The present silicone resin composition may further comprise an adhesion-imparting agent. Examples of the adhesion-imparting agent include linear or cyclic organosiloxane oligomer, and organooxysilyl-modified isocyanurate and/or a hydrolysis and condensation products thereof such as an organosiloxane-modified isocyanurate, which agent has 4 to 50, preferably 4 to 20, silicon atoms and at least two, preferably two or three, reactive groups selected from a hydrogen atom bonded to a silicon atom, an alkenyl group such as -Si-CH=CH₂ group, an alkoxysilyl group such as trimethoxysilyl group, an epoxy group such as a glysidoxypropy group and 3,4-epoxycyclohexylethyl group and a (meth)acrylate group, each bonded to a silicon atom. The adhesion-imparting agent may be used alone or in a combination of two or more.

Examples of the adhesion-imparting agent include the following ones.

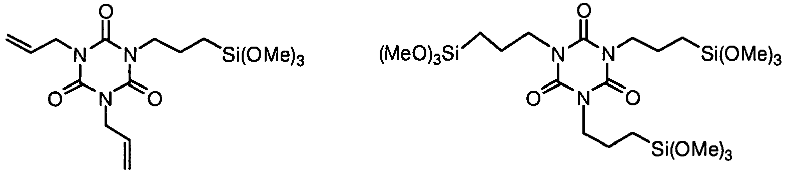

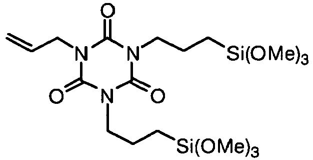

Further, the adhesion-imparting agent may be one represented by the following formula.

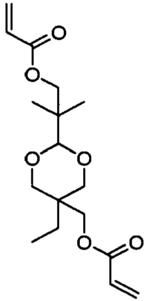

The amount of the adhesion-imparting agent ranges from 0.1 to 20 part by mass, preferably 0.2 to 10 parts by mass, more preferably 0.5 to 5 parts by mass, relative to 100 parts by mass of the component (A) . If the amount is too large, the hardness of the cured product obtained is adversely affected and tack may occur on the surface of the cured product.

### Other Additives

The present silicone resin composition may further comprise a compound which inhibits or controls the curing reaction, in addition to components (A) to (D). Examples of the compound include phosphorus-containing compounds such as triphenylphosphine; nitrogen-containing compounds such as tributylamine, tetramethylethylenediamine and benzotriazole; sulfur-containing compounds, acetylene compounds, compounds having two or more alkenyl groups, hydroperoxy compounds and maleic acid derivatives. The degree of the effect of delaying the curing reaction varies greatly depending on the chemical structure of the compounds. Accordingly, the amount should be adjusted for each compound. In general, if the amount is too small, long-term storage stability at room temperature cannot be obtained. If the amount is too large, the curing reaction is inhibited.

Further, as an optional component, use may be made of inorganic fillers such as fumed silica, crystalline silica, precipitated silica, hollow filler, polyorganosilsesquioxane, fumed titanium dioxide, magnesium oxide, zinc oxide, iron oxide, aluminum hydroxide, magnesium carbonate, calcium carbonate, zinc carbonate, layered mica, carbon black, diatomite and glass fiber; and these fillers which are surface treated with organosilicon compounds such as organoalkoxysilanes, organochlorosilanes, organosilazanes and low-molecular-weight siloxanes. Further silicone elastomer powder and silicone resin powder can be used. These additives may be properly added in such an amount that the effects of the present invention are not obstructed.

Further, the present silicone resin composition may contain, for the purpose of adjusting the hardness of a silicone gel product, organopolysiloxanes having one hydrogen atom bonded to a silicon atom, referred to as SiH, in a molecule; uncurable organopolysiloxanes which do not have a hydrogen atom nor alkenyl group bonded to a silicon atom; as an adhesion-imparting agent, organopolysiloxanes having an alkoxy group and a hydrogen atom or alkenyl group each bonded to a silicon atom in a molecule, organic silicon compound having an alkoxy group and an epoxy group each bonded to a silicon atom in a molecule, an organic silicon compound having an alkoxy group and a methacryloxy group each bonded to a silicone atom in a molecule; and organic solvents, creep hardening inhibitors, heat resistance-imparting agents, flame retardants, plasticizers, thixotropy-imparting agents, pigments, dyes and fungicides, all in such an amount that the effects of the present invention are not obstructed.

The present silicone resin composition can be prepared by homogeneously mixing the afore-mentioned components in the pre-defined compositional ratio with a planetary mixer or Shinagawa mixer in any conventional method. The viscosity of the present silicone resin composition, as determined at 23 degrees C. with a rotational viscometer, ranges preferably from 10 to 1,000,000 mPa·s, more preferably 100 to 100,000 mPa·s.

For the present silicone composition, start of the curing reaction can be flexibly set with irradiation of light. The curing reaction of the prepared silicone resin composition does not proceed at room temperature, the viscosity of the composition does not increase and, therefore, the pot life of the composition is good. In the present invention, the pot life is an index of workability such that the silicone resin composition keeps a practical viscosity and is defined as a period of time from the moment of mixing all of the components to the moment when the viscosity at 23 degrees C. of the composition becomes twice as large as the viscosity right after the mixing.

The present invention is a method for curing the afore-mentioned silicone composition. The present method is characterized in that the method comprises a step of irradiating the silicone resin composition with the afore-mentioned light having an irradiance in the specific wavelength to make the silicone resin composition to gel. Irradiation of the silicone resin composition with the light having the specific wavelength for 0.5 to 10 seconds, in particular 1 to 5 seconds, causes the compound to gel in the subsequent 10 to 600 seconds, in particular 60 to 300 seconds.

In the present method, the gel composition is completely cured with heat, whereby the silicone resin composition cures keeping an initial shape without flowing during the heating. The heating is conducted at 25 to 200 degrees C., preferably 100 to 180 degrees C., for 3 minutes to 72 hours, preferably 1 to 6 hours. Curing conditions may be selected for balance among process conditions, productivity and heat resistance of a light emitting element and a housing. In the case of transfer molding or injection molding, the molding may be conducted at a temperature of 150 to 180 degrees C. and a pressure of 20 to 50 kgf / cm² for 1 to 5 minutes. Further, post-curing may be conducted at 150 to 200 degrees C. for 1 to 4 hours.

The cured product obtained in the present method has good heat resistance and transparency. The present invention can provide a cured product whose transparency through 1mm thickness at wavelength of 450nm is 90 to 100 %, in particular 95 to 100 %, at 23 degrees C. Therefore, the cured product obtained in the present method is useful as an encapsulating material for optical semiconductor elements such as light emitting diodes (LED), organic electroluminescent elements (organic EL), laser diodes and LED arrays. The reason why the transparency through 1mm thickness is required is that a lens formed by encapsulating a LED chip with the composition is about 1mm thick.

The manner for encapsulating an optical semiconductor element with the present cured product is not limited to any particular one. For example, an optical semiconductor element is placed in a housing having an opening, and the present composition is fed to cover the optical semiconductor element, and then the composition is cured. Alternatively, an optical semiconductor element is mounted on a matrix-type substrate, and encapsulated in a printing method, transfer molding, injection molding or compression molding. Where an optical semiconductor element is coated and protected in a potting or injection method, the present composition is preferably liquid. Where an optical semiconductor device is produced in transfer molding, a liquid state of the composition may be thickened to solid, and pelletized to be used in molding.

### EXAMPLES

The present invention will be explained below in further detail with reference to a series of the Examples and Comparative Examples, though the present invention is in no way limited by these Examples. In the following descriptions, the term "part" refers to "part by mass". The viscosity was determined with a Digital Viscometer, DV-II+ PRO, ex Brookfield Co., at a temperature of 23 degrees C.

### [Preparation Examples 1 to 3]

### (A) Organopolysiloxane with alkenyl groups

Branched polymethylvinylsiloxane which comprises 16 mole % of the SiO₂ unit, 20 mole % of the (CH₃)₃SiO_{1/2} unit, 4 mole % of the Vi(CH₃)₂SiO_{1/2} unit and 60 mole % of the (CH₃)₂SiO unit, and a vinyl group of 54mmols per 100 g, and has a viscosity of 40 Pa.s, ex Shin-Etsu Chemical Co., Ltd. The weight average molecular weight of this siloxane, as determined by GPC, reduced to polystyrene, was 63,000. Conditions for the determination were as shown below.
Solvent: Tetrahydrofuran (THF)
Flow rate: 0.6mL/min.
Detector: Differential refractive index detector (RI)
Column Temperature: 40 degrees C.
Injection Volume: 20µl of a THF solution containing 0.5 % by weight of the siloxane.

### (B) Organohydrogenpolysiloxane

Methylhydrogenpolysiloxane, ex Shin-Etsu Chemical Co., Ltd., represented by the following formula, wherein the amount of the SiH group is 1.56 mmols per 100g and the viscosity is 5mPa.s.

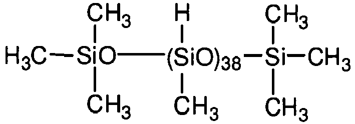

### (C) Photoactive catalyst

(c-1) Bis(acetylacetonato)platinum(II), ex Tokyo Chemical Industry Co., Ltd.
(c-2) (Methylcyclopentadienyl)trimethyl platinum, ex Sigma-Aldrich Japan Co, Ltd.

### (D) Adhesion-imparting agent

(d-1) Adhesion-imparting agent 1, ex Shin-Etsu Chemical Co., Ltd. 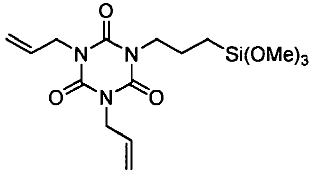
(d-2) Adhesion-imparting agent 2, ex Kyoeisha Chemical Co., Ltd.

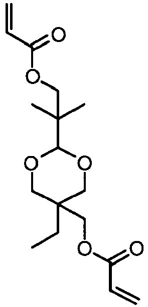

### Preparation of Silicone Resin Compositions 1 to 3

The aforesaid components were mixed in the amounts shown in the following Table 1, stirred homogeneously with a mixer and degassed to obtain colorless, transparent and liquid compositions. In Table 1, the amounts of the platinum catalysts are the amount of platinum group metal, relative to the total amount of components (A) and (B) . The value, SiH group/ Vi group, in Preparations 1 and 2 and Referential Example are the equivalent of the SiH group in the component (B), relative to the total equivalent of the vinyl group in the components (A) and (D).

### Preparation of Silicone Resin Composition 4

As a silicone resin composition for reference, silicone resin composition 4 comprising a non-photoactive catalyst was prepared. The aforesaid components (A), (B) and (D), a non-photoactive platinum vinylsiloxane complex, ex Shin-Etsu Chemical Co., Ltd., and ethynylcyclohexanol, ex Shin-Etsu Chemical Co., Ltd., as an acetylenic alcohol type of a curing inhibitor were blended in the amounts shown in Table 1, stirred homogeneously with a mixer and degassed to obtain a colorless, transparent and liquid composition.

### Pot life

Each of the silicone resin compositions was put in a brown bottle, and the bottle was dipped in a bath of a constant temperature, 23 degrees C. and left for two weeks. The viscosity of the composition after two weeks was determined and a change relative to the initial viscosity was calculated. The results are as shown in Table 1.

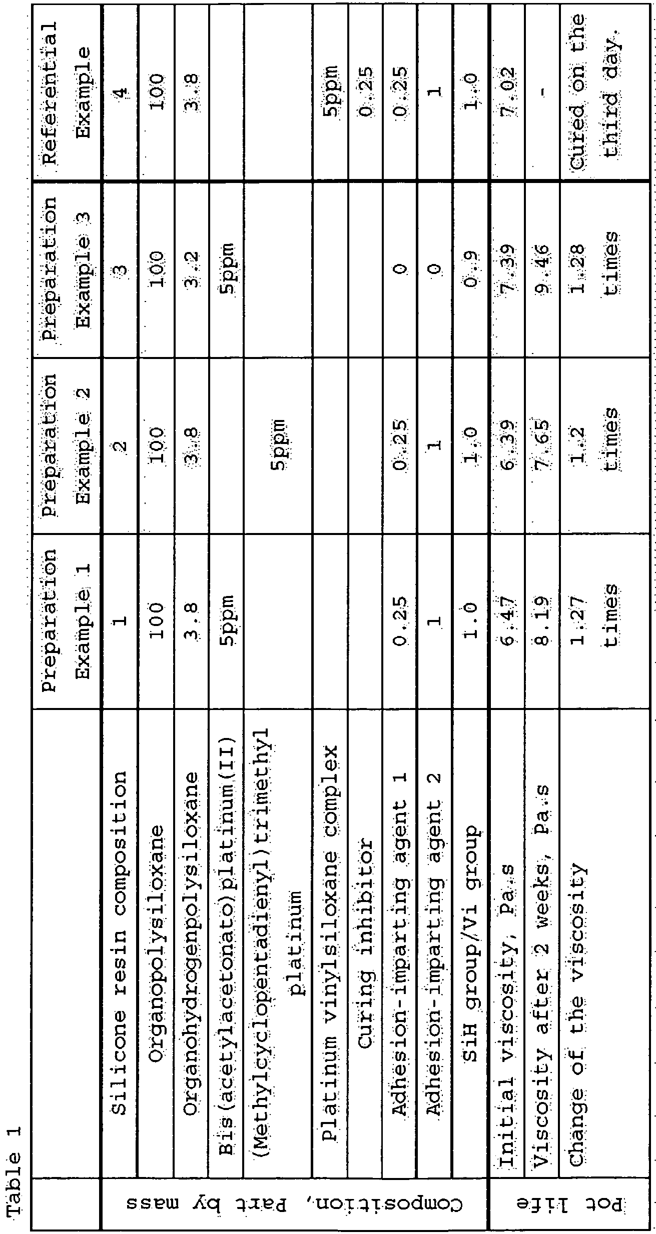

The non-photoactive platinum catalyst is active without light irradiation and, therefore, the silicone resin composition 4 cured on the third day despite the curing inhibitor contained. In contrast, the photoactive platinum catalysts remain inactive without light irradiation and, therefore, the change of viscosity of the silicone resin compositions 1 to 3 after two weeks were from 1.2 to about 1.3 times and, thus, the pot life was excellent.

### Flowability after light irradiation

The flowabilties of the silicone resin compositions 1 to 3 after the light irradiation thereto in the conditions described below were evaluated. The surface of each of the compositions was touched with a finger. If the resin did not move to the finger, this was expressed as "non-flowable." The results are shown in Table 2.

### Examples 1 to 3

The silicone resin compositions 1 to 3 were poured in a Teflon (registered trademark) mold to form a sheet having a thickness of 2mm, and irradiated with light of 365 nm with a UV-LED, ex MeCan Imaging Inc., for 3 seconds up to 300mJ/cm² of integrated quantity of light and, then, were left standing for 3 minutes.

### Examples 4 to 6

The silicone resin compositions 1 to 3 were poured in a Teflon (registered trademark) mold to form a sheet having a thickness of 2 mm. The silicone resin compositions was irradiated with the light having a maximum peak of irradiance at wavelength of 365 nm, where the light of wavelength shorter than 300nm was cut with a 365 nm Band Pass Filter, ex Ushio Inc. to make the irradiance of the light of wavelength shorter than 300nm 5 % or less of the irradiance at the maximum peak, for 3 seconds up to 300mJ/cm² of integrated quantity of light and, then, was left standing for 3 minutes. The light source was an ultraviolet irradiation equipment having a conveyor, ex Iwasaki Electric Co., Ltd. The emission spectra of these lights are shown in Figure 1. The spectrum distribution was determined with a spectroradiometer, USR-45D, ex Ushio Inc. In Figure 1, the spectrum of the light filtered with the Band Pass Filter is in a solid line. The spectrum of the light which was not filtered by the Band Pass Filter is in a dotted line.

### Comparative Examples 1 to 3

The silicone resin compositions 1 to 3 were poured in a Teflon (registered trademark) mold to form a sheet having a thickness of 2 mm, irradiated light which has a maximum irradiance at 365 nm and emission spectra in the region of 200 to 400 nm with the UV-LED, ex MeCan Imaging Inc., for 3 seconds up to 300mJ/cm² of integrated quantity of light and, then, left standing for 3 minutes.

**Table: 2**

| | Examples | | | | | | Comaprative Examples | | |
|---|---|---|---|---|---|---|---|---|---|
| | 1 | 2 | 3 | 4 | 5 | 6 | 1 | 2 | 3 |
| Silicone resin comosition | 1 | 2 | 3 | 1 | 2 | 3 | 1 | 2 | 3 |
| Wavelength region | 365 nm | | | Light filtered with the optical filter. | | | 200 to 400 nm | | |
| Flowability | Non-flowable | Non-flowable | Non-flowable | Non-flowable | Non-flowable | Non-flowable | Flow-able | Flow-able | Flow-able |

In Comparative Examples 1 to 3 where the silicone resin composition was irradiated with the light having emission spectrum in the wavelength region of 200 to 400 nm, the compositions after the irradiation were flowable and did not gel. In contrast, in Examples 1 to 3 where the silicone resin composition was irradiated with the light having a single emission at 365 nm and in Examples 4 to 6 where the silicone resin composition was irradiated with the light where the light of wavelength shorter than 300nm was cut with a Band Pass Filter, the compositions after the irradiation were not flowable and geled.

### Shape-keeping property during heating

A space having a base of 6.0 cm x 1.0 cm and a height of 1 mm was partitioned with a tape on a glass plate of 7.5 cm x 2.5 cm, and the silicone resin compositions 1 to 3 were poured therein and irradiated with the light in the afore-mentioned irradiation conditions. Subsequently, the tape was peeled off and the composition was heated in an oven at 150 degrees C. for 2 hours to obtain a colorless and transparent cured product. Change in shape of the composition during the heating was observed with the naked eyes. When the initial shape did not change, it was evaluated as "good". When the initial shape changed, it was evaluated as "bad" . Preferred is that the change of the shape is 1 % or less in the longitudinal and lateral directions. Further, as Comparative Example 4, the silicone resin composition 4 was irradiated with the light and heated in the same conditions as in Example 1 and evaluated. The results are shown in Table 3.

### Hardness of the cured products after heating

A space having a base of 6.0 cm x 1.0 cm and a height of 1 mm was partitioned with a tape on a glass plate of 7.5 cm x 2.5 cm, and the silicone resin compositions 1 to 4 were poured therein. The silicone resin compositions 1 to 3 were irradiated with the light in the afore-mentioned irradiation conditions. The silicone resin composition 4 was irradiated with the light in the same conditions as in Example 1. Subsequently, the tape was peeled off and the composition was heated in an oven at 150 degrees C. for 2 hours to obtain a colorless and transparent cured product. Three pieces of each of the cured products were stacked on top of another to form a sample having thickness of 6 mm, and the hardness of them right after the curing was determined with a durometer of type A in accordance with the Japanese Industrial Standards K 6253. Further, the hardness of them was determined after left at 150 degrees C. for 2 weeks. The results are shown in Table 3.

### Transparency of the cured products after heating

The cured product having thickness of 1 mm which was subjected to the aforesaid test for a shape-keeping property during heating, was left in an oven at 200 degrees C. for two weeks. Then, the transparency of the light having an optical path of 1 mm and a wavelength of 450 nm was determined at 23 degrees C. with a spectrophotometer, U-4100, ex Hitachi, Ltd. The results are shown in Table 3.

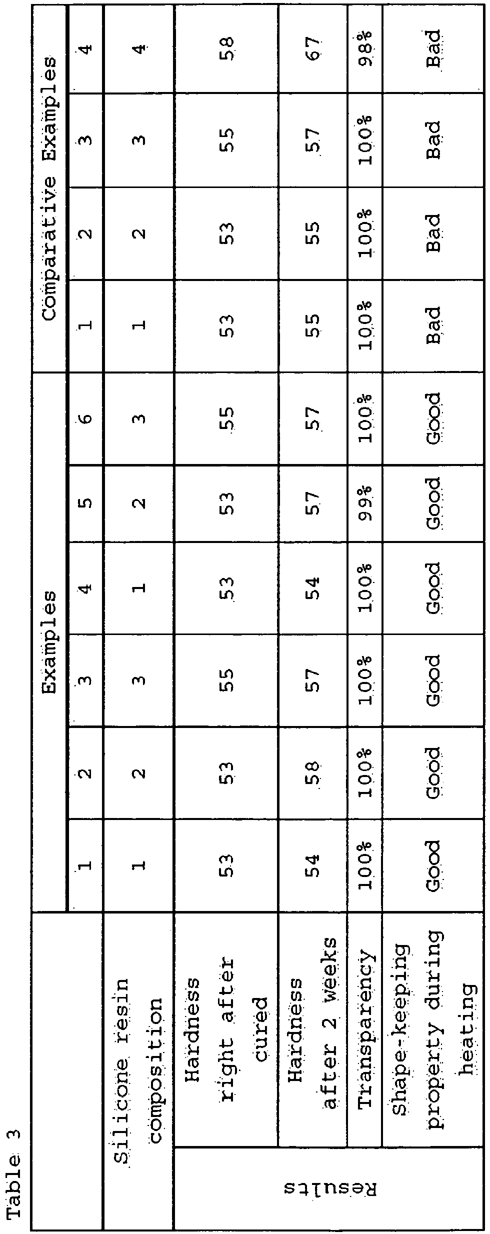

The hardness of the cured product obtained from the silicone resin composition 4 comprising the non-photoactive curing catalyst changed greatly after left at 150 degrees C. for 2 weeks . Further, this silicone resin composition does not gel with light irradiation, so that the composition flowed during the heating and cannot keep the initial shape. The cured products obtained in Comparative Examples 1 to 3 where the compositions were cured by irradiation with the light having emission spectra in the region of wavelength 200 to 400 nm and subsequent heating had the good heat resistance and transparency, but the composition did not gel by the irradiation, so that the composition flowed during the heating and could not keep the initial shape. In contrast, in the present method, the silicone resin composition was cured, keeping the initial shape and provided the cured products having excellent heat resistance and transparency.

### INDUSTRIAL APPLICABILITY

In the present method of curing, the resin composition does not flow with heating and can be cured, keeping an initial shape and, therefore, the cured product has a desired shape. Further, the present silicone composition has a good pot life and can provide a cured product having excellent heat resistance and transparency and, therefore, is useful as an encapsulating material for optical semiconductor elements such as light-emitting diodes.

## Claims

1. A method for curing a silicone resin composition with heat, wherein the silicone resin composition comprises
(A) an organopolysiloxane having at least two alkenyl groups per molecule,
(B) an organohydrogenpolysiloxane having, per molecule, at least two hydrogen atoms each bonded to a silicon atom in such an amount that the ratio of the total mole of the hydrogen atoms bonded to the silicon atom in the component(B) to the total mole of the alkenyl groups in the component (A) is 0.1 to 4.0, and
(C) a catalytic amount of a photoactive catalyst,
wherein the method is **characterized by** comprising a step of irradiating the silicone resin composition with light before the step of heating, the light has a maximum peak of irradiance in the region of wavelengths of 300 to 400nm and the irradiance of light of wavelength shorter than 300nm is 5 % or less of the irradiance at the maximum peak.

2. The method according to claim 1, wherein the method further comprises a step of cutting light of wavelengths shorter than 300nm with an optical filter to make the irradiance of light of wavelength shorter than 300nm 5 % or less of the irradiance at the maximum peak.

3. The method according to claim 1 or 2, wherein the silicone resin composition gels by the step of irradiation.

4. The method according to any one of claims 1 to 3, wherein the organopolysiloxane (A) comprises SkiO_{4/2} units and R₃SiO_{1/2} units, wherein R is, independently of each other, a substituted or unsubstituted, monovalent hydrocarbon group having 1 to 10 carbon atoms.

5. The method according to claim 4, wherein the organopolysiloxane (A) further comprises R₂SiO units and/or RSiO_{3/2} units, wherein R is, independently of each other, a substituted or unsubstituted, monovalent hydrocarbon group having 1 to 10 carbon atoms.

6. The method according to any one of claims 1 to 5, wherein the component (C) is a platinum beta-diketonate complex.

7. The method according to claim 6, wherein the component (C) is a bis(acetylacetonato)platinum(II).

8. The method according to any one of claims I to 7, wherein the method comprises curing said silicone resin composition to thereby encapsulate an optical semiconductor element with the cured product.

## Patentansprüche

1. Verfahren zum Härten einer Siliconharzzusammensetzung mit Wärme, wobei die Siliconharzzusammensetzung umfasst
(A) ein Organopolysiloxan mit mindestens zwei Alkenylgruppen pro Molekül,
(B) ein Organohydrogenpolysiloxan, mit mindestens zwei Wasserstoffatome pro Molekül, jeweils an ein Siliciumatom in einer solchen Menge gebunden, daß das Verhältnis der gesamten Mole der an das Siliciumatom in der Komponente (B) gebundenen Wasserstoffatome zur Gesamtzahl der Mole der Alkenylgruppen in der Komponente (A) 0.1 bis 4.0 beträgt, und
(C) eine katalytische Menge eines photoaktiven Katalysators,
wobei das Verfahren durch das Umfassen eines Schrittes des Bestrahlens der Siliconharzzusammensetzung mit Licht vor dem Schritt des Erhitzens gekennzeichnet ist, wobei das Licht ein Maximum der Bestrahlungsstärke im Bereich der Wellenlängen von 300 bis 400 nm aufweist, und wobei die Bestrahlungsstärke des Lichts einer Wellenlänge kürzer als 300 nm 5% oder weniger der Bestrahlungsstärke beim Maximum beträgt.

2. Verfahren gemäß Anspruch 1, wobei das Verfahren ferner einen Schritt des Ausschneidens von Licht mit Wellenlängen kürzer als 300 nm mit einem optischen Filter umfasst, um die Bestrahlungsstärke von Licht einer Wellenlänge kürzer als 300 nm 5% oder weniger der Bestrahlungsstärke beim Maximum zu erzielen.

3. Verfahren nach Anspruch 1 oder 2, wobei die Siliconharzzusammensetzung durch den Schritt der Bestrahlung geliert.

4. Verfahren nach einem der Ansprüche 1 bis 3, wobei das Organopolysiloxan (A) SiO_{4/2}-Einheiten und R₃SiO_{1/2}-Einheiten umfasst, wobei R unabhängig voneinander eine substituierte oder unsubstituierte, einwertige Kohlenwasserstoffgruppe mit 1 bis 10 Kohlenstoffatomen ist.

5. Verfahren nach Anspruch 4, wobei das Organopolysiloxan (A) ferner R₂SiO-Einheiten und / oder RSiO_{3/2}-Einheiten umfasst, wobei R unabhängig voneinander eine substituierte oder unsubstituierte, einwertige Kohlenwasserstoffgruppe mit 1 bis 10 Kohlenstoffatomen ist.

6. Verfahren nach einem der Ansprüche 1 bis 5, wobei die Komponente (C) einen Platin-beta-Diketonat-Komplex darstellt.

7. Verfahren nach Anspruch 6, wobei die Komponente (C) ein Bis(acetylacetonato)platin(II) ist.

8. Verfahren nach einem der Ansprüche 1 bis 7, wobei das Verfahren ein Härten der Silikonharzzusammensetzung umfasst, um dadurch ein optisches Halbleiterelement mit dem gehärteten Erzeugnis einzukapseln.

## Revendications

1. Procédé de durcissement d'une composition de résine de silicone avec de la chaleur, dans lequel la composition de résine de silicone comprend
(A) un organopolysiloxane présentant au moins deux groupes alcényle par molécule,
(B) un organohydrogénopolysiloxane présentant, par molécule, au moins deux atomes d'hydrogène chacun liés à un atome de silicium dans une quantité telle que le rapport du nombre total de moles des atomes d'hydrogène liés à l'atome de silicium dans le constituant (B) au nombre total de moles des groupes alcényle dans le constituant (A) est de 0,1 à 4,0, et
(C) une quantité catalytique d'un catalyseur photoactif,
dans lequel le procédé est **caractérisé en ce qu'**il comprend une étape d'irradiation de la composition de résine de silicone avec de la lumière avant l'étape de chauffage, la lumière présente un pic maximal d'irradiation dans la région des longueurs d'onde de 300 à 400 nm et l'irradiation de lumière de longueur d'onde plus courte que 300 nm est inférieure ou égale à 5 % de l'irradiation au pic maximal.

2. Procédé selon la revendication 1, dans lequel le procédé comprend de plus une étape de limitation de lumière des longueurs d'onde plus courtes que 300 nm avec un filtre optique pour rendre l'irradiation de lumière de longueur d'onde plus courte que 300 nm inférieure ou égale à 5 % de l'irradiation au pic maximal.

3. Procédé selon la revendication 1 ou 2, dans lequel la composition de résine de silicone gélifie par l'étape d'irradiation.

4. Procédé selon l'une quelconque des revendications 1 à 3, dans lequel l'organopolysiloxane (A) comprend des unités SiO_{4/2} et des unités R₃SiO_{1/2}, dans lesquelles les R sont, indépendamment les uns des autres, un groupe hydrocarboné monovalent, substitué ou non substitué ayant de 1 à 10 atomes de carbone.

5. Procédé selon la revendication 4, dans lequel l'organopolysiloxane (A) comprend de plus des unités R₂SiO et/ou des unités RSiO_{3/2}, dans lesquelles les R sont, indépendamment les uns des autres, un groupe hydrocarboné monovalent, substitué ou non substitué ayant de 1 à 10 atomes de carbone.

6. Procédé selon l'une quelconque des revendications 1 à 5, dans lequel le constituant (C) est un complexe de bêta-dicétonate de platine.

7. Procédé selon la revendication 6, dans lequel le constituant (C) est un bis(acétylacétonato)platine(II).

8. Procédé selon l'une quelconque des revendications 1 à 7, dans lequel le procédé comprend le durcissement de ladite composition de résine de silicone pour encapsuler par-là un élément de semi-conducteur optique avec le produit durci.
